Europäisches Patentamt

European Patent Office

Office européen des brevets

(11) Publication number: **0 381 396**
**A1**

# EUROPEAN PATENT APPLICATION

(21) Application number: **90300867.0**

(22) Date of filing: **26.01.90**

(51) Int. Cl.5: **H01L 29/812, H01L 29/205**

(30) Priority: **31.01.89 JP 22095/89**

(43) Date of publication of application:
**08.08.90 Bulletin 90/32**

(84) Designated Contracting States:
**DE FR GB**

(71) Applicant: **SONY CORPORATION**
**7-35 Kitashinagawa 6-Chome Shinagawa-ku**
**Tokyo 141(JP)**

(72) Inventor: **Ogawa, Masamichi, c/o Patents**
**Division**
**Sony Corporation, 6-7-35 Kitashinagawa**
**Shinagawa-ku, Tokyo 141(JP)**

(74) Representative: **Thomas, Christopher Hugo et**
**al**
**D Young & Co 10 Staple Inn**
**London WC1V 7RD(GB)**

(54) **Compound semiconductor devices.**

(57) A field-effect transistor having a first semiconductor layer (undoped GaAs) (2) formed onto a semiconductor substrate (semi-insulating GaAs) (1), a strained semiconductor channel layer (undoped InGaAs) (8) formed onto the first layer (2) and an electron supply semiconductor layer (doped AlGaAs) (3) formed onto the channel layer (8) for inducing a two-dimensional electron gas (9) therein. The composition of the channel layer (8) changes from that of the first layer (2) at the interface therewith to that of a lower bandgap material at the interface with the electron supply layer (3). The thickness of the channel layer (8) can be increased and a sudden change in growth temperature at the time of growing the channel layer (8) can be avoided, which allows for better controllability of thickness and growth temperature of the channel layer (8).

*Fig. I*

## COMPOUND SEMICONDUCTOR DEVICES

This invention relates to compound semiconductor devices, and, more particularly, to compound semiconductor devices using a two-dimensional electron gas.

Hitherto, as a compound semiconductor device using a two-dimensional electron gas (2DEG), a high electron mobility transistor (HEMT) has been known. In an HEMT, the 2DEG which is formed in the channel layer near the heterointerface between the channel layer and the electron supply layer is used as a channel. An n type AlGaAs/GaAs HEMT using an n type AlGaAs layer and an undoped GaAs layer as an electron supply layer and a channel layer, respectively, is known.

In recent years, in the n type AlGaAs/GaAs HEMT, there has been proposed a method whereby the energy difference $\Delta Ec$ of the conduction band edge (Ec) at the n type AlGaAs/GaAs heterointerface is increased by introducing an InGaAs layer of constant composition whose electron affinity is larger than that of GaAs, between the n type AlGaAs layer and the GaAs layer, thereby increasing the 2DEG concentration ns. In this case, since the InGaAs lattice constant is larger than that of GaAs, the InGaAs layer is lattice-mismatched to the GaAs layer. Thus, a lattice distortion occurs in the InGaAs layer. For this reason, the InGaAs layer is called a pseudomorphic (or strained) layer. When the thickness of the InGaAs layer is set to a value called the critical layer thickness, which is determined by the composition of this layer, or more, misfit dislocations occur at the interface between the InGaAs layer and the GaAs layer. Therefore, to suppress the occurrence of such misfit dislocations, it is necessary to set the thickness of the InGaAs layer to the critical layer thickness or less.

To improve the characteristics of the HEMT, it is necessary to increase the 2DEG concentration ns and the saturation velocity vs of electrons. In the case where the InGaAs layer having a constant composition is used as a pseudomorphic layer, it is advantageous because as the In composition is large, the 2DEG concentration ns and the saturation velocity vs increase. However, there are the following problems (see Jpn. J. Appl. Phys. 26 - (1987) 539).

(1) As the In composition is large, the critical layer thickness decreases. For instance, it has been known that when the In concentration is set to 20%, the critical layer thickness is 20 nm or less.

(2) When the thickness of the InGaAs layer reaches a value (< 20 nm) such as to cause the quantum effect, the thickness is equal to or less than the critical layer thickness at which energy levels rise. Thus, even if the In concentration increases, the 2DEG concentration ns is not increased significantly.

Therefore, in an n type AlGaAs/InGaAs/GaAs HEMT using an InGaAs layer as a pseudomorphic layer, when the 2DEG concentration ns is intended to be maximised, the In concentration of the In-GaAs layer is set to a value within a range from 15 to 20%, and the thickness is set to a value within a range from 20 to 15 nm. Therefore, the freedom in selection of the In concentration and the InGaAs thickness is small. On the other hand, in an n type AlGaAs/InGaAs/GaAs HEMT, electrons are confined to the quantum well formed by the double heterojunctions comprising the n type AlGaAs/InGaAs heterojunction and the InGaAs/GaAs heterojunction, and thereby the 2DEG is formed. Therefore, in the case where defects such as alloy clusters or the like and other scatterers exist in the double heterojunctions, the characteristics of the HEMT are likely to be deteriorated as a result.

Further, when the HEMT is fabricated by molecular beam epitaxy (MBE), the growth temperature of the InGaAs layer needs to be set to be lower than the growth temperature of the GaAs layer or the AlGaAs layer by about 100°C. For this purpose, for instance, after the GaAs layer has been grown, it is necessary immediately to lower the growth temperature by about 100°C and to grow the InGaAs layer. However, it is not easy suddenly to change the growth temperature with good controllability. If the controllability of the growth temperature is bad, there is a risk such that alloy clusters or the like are formed at the heterointerfaces of the double heterojunctions, and the characteristics of the HEMT are deteriorated. Therefore, to prevent this problem, attention must be paid to the control of the growth temperature. On the other hand, since the thickness of the InGaAs layer is so small (20 to 15 nm as mentioned above), it is not so easy to grow the InGaAs layer with good controllability of the thickness.

According to the present invention there is provided a compound semiconductor device having a channel layer and an electron supply layer and using a two-dimension electron gas, wherein said channel layer near the interface between said channel layer and said electron supply layer is formed as a graded layer.

The graded layer denotes a layer whose composition changes continuously. At the interface between the graded layer and the channel layer, the graded layer has the same composition as the channel layer. The composition of the graded layer changes continuously such that $\Delta$ Ec increases towards the electron supply layer. The graded layer forms a pseudomorphic layer.

Since the channel layer near the interface between the channel layer and the electron supply layer is formed as a graded layer, by using the graded layer as a pseudomorphic layer, the critical layer thickness of the pseudomorphic layer is larger than that in the case of using the pseudomorphic layer having a constant composition. Therefore, the thickness of the pseudomorphic layer can be increased as compared with a pseudomorphic layer of constant composition. Thus, for instance, in the case of growing the pseudomorphic layer by MBE, the thickness can be easily controlled. Moreover, in growing the pseudomorphic layer, the growth temperature does not need to be suddenly changed. Further, the freedom to change the energy band shape is increased. In addition, since only the single heterojunction of the electron supply layer and the graded layer exists in the compound semiconductor device, the influence of alloy clusters is reduced.

The invention will now be described by way of example with reference to the accompanying drawings, in which:

Figure 1 is a cross sectional view showing an embodiment of n type AlGaAs/InGaAs/GaAs HEMT according to the present invention;

Figure 2 is an energy band diagram showing the energy band structure of the HEMT of Figure 1;

Figure 3 is a graph showing the In composition distribution of the InGaAs layer in the HEMT of Figure 1;

Figure 4 is an energy band diagram showing the energy band structure of a previously proposed n type AlGaAs/InGaAs/GaAs HEMT in which an InGaAs layer having a constant In composition is used as a pseudomorphic layer; and

Figure 5 is a graph showing the In composition distribution of the InGaAs layer in the HEMT of Figure 4.

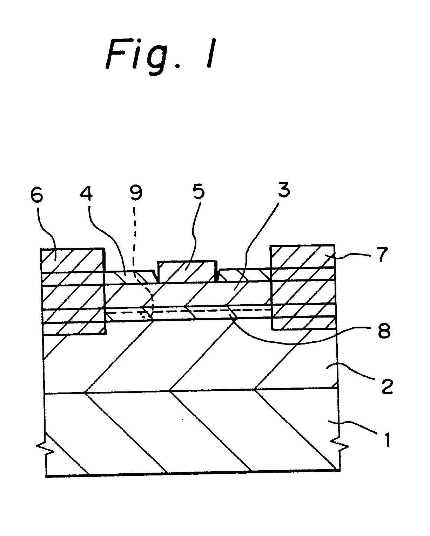

Referring to Figure 1, the embodiment is an n type AlGaAs/InGaAs/GaAs HEMT using an InGaAs layer as a pseudomorphic layer, and comprises an undoped GaAs layer 2 forming a channel layer, an n type AlGaAs layer (for instance, an n type $Al_{0.3}Ga_{0.7}$ As layer) 3 forming an electron supply layer, and an n type GaAs layer 4 forming a cap layer, sequentially formed on a semi-insulating GaAs substrate 1. The thickness of the AlGaAs layer 3 is set to, for example, about 45 nm. A Schottky gate electrode 5 is formed on the AlGaAs layer 3. A source electrode 6 and a drain electrode 7 are also provided.

An InGaAs layer 8 is formed between the GaAs layer 2 and the AlGaAs layer 3. The thickness of the InGaAs layer 8 is, for example, about 30 nm.

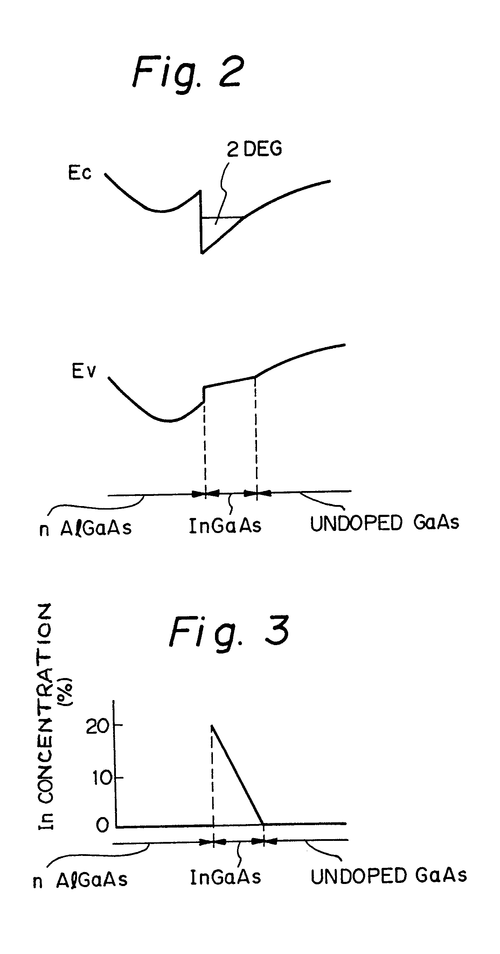

As shown in Figure 3, the In concentration of the InGaAs layer 8 increases linearly from the undoped GaAs layer 2 towards the n type AlGaAs layer 3 from zero to, for example, 20%. A 2DEG 9 is formed in the InGaAs layer 8 near the heterointerface between the AlGaAs layer 3 and the InGaAs layer 8.

An example of a method of fabricating such an HEMT will now be described.

As shown in Figure 1, the undoped GaAs layer 2 is first grown on the semi-insulating GaAs substrate 1 by, for example, MBE. The InGaAs layer 8 is subsequently grown on the GaAs layer 2. In this case, in order to form the InGaAs layer 8 as a graded layer, the temperature of, for example, a Knudsen cell forming the molecular beam source of In is, for example, linearly gradually raised during the growth. When the InGaAs layer 8 has been grown to a desired thickness, the In concentration is set to, for example, 20%. Due to this, the InGaAs layer 8 having the In concentration distribution as shown in Figure 3 is grown. In the case of growing the InGaAs layer 8 after the GaAs layer 2 has been grown, the rate of decrease of the growth temperature is made slower than that in the case of an InGaAs layer having a constant In concentration as in the previously proposed device. After the Si-doped n type AlGaAs layer 3 has been subsequently grown on the InGaAs layer 8 by MBE, the n type GaAs layer 4 is grown on the AlGaAs layer 3. Next, an ohmic metal film is formed on the GaAs layer 4 by, for example, an evaporation process. After the ohmic metal film has been patterned into a predetermined shape, it is thermally treated, thereby alloying the ohmic metal film with the GaAs layer 4, the AlGaAs layer 3, the InGaAs layer 8, and the GaAs layer 2 to form the source electrode 6 and the drain electrode 7. Then the AlGaAs layer 3 is partially exposed by recess etching. Thereafter, the Schottky gate electrode 5 is formed on the exposed AlGaAs layer 3, thereby completing the HEMT.

The Schottky gate electrode 5 may be formed prior to the source electrode 6 and the drain electrode 7.

Figure 2 shows the energy band structure of the embodiment. Ev indicates the valence band edge. As shown in Figure 2, an inverse triangular deep quantum well is formed in the InGaAs layer 8 near the heterointerface between the AlGaAs layer 3 and the InGaAs layer 8, and the 2DEG 9 is formed in the quantum well. In this case, at the interface of the InGaAs layer 8 and the GaAs layer 2, the In concentration is set to zero. That is, at the interface of the InGaAs layer 8 and the GaAs layer 2, the InGaAs layer 8 is actually the GaAs layer. Therefore, the energy band of the InGaAs layer 8 is continuous with the energy band of the undoped GaAs layer 2.

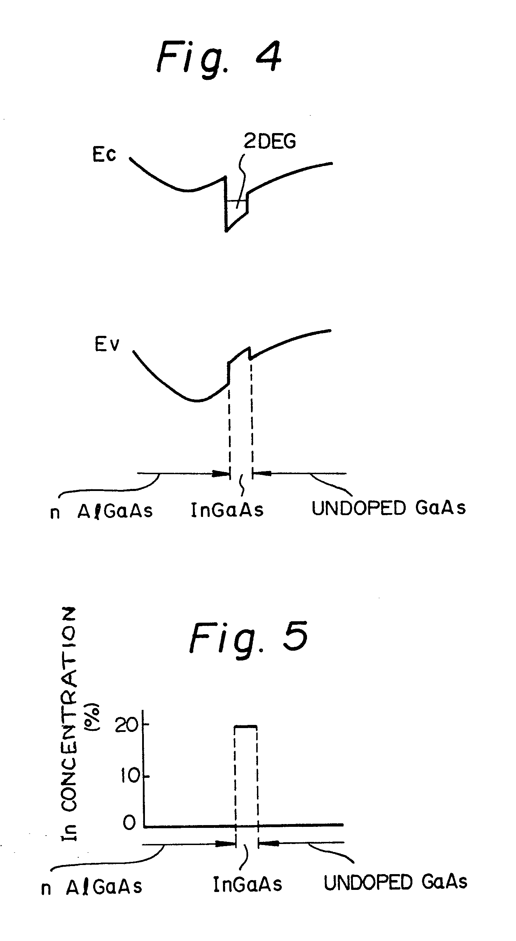

On the other hand, for comparison, the energy band structure of a previously proposed n type AlGaAs/InGaAs/GaAs HEMT using an InGaAs layer having a constant In concentration as a pseudomorphic layer is shown in Figure 4. Figure 5 shows the In concentration distribution in this case.

In the embodiment, the InGaAs layer 8 as a pseudomorphic layer has been formed as a graded layer, whose In concentration changes linearly from the undoped GaAs layer 2 towards the n type AlGaAs layer 3. Therefore, while in the HEMT using the InGaAs layer having a constant In concentration as a pseudomorphic layer as shown in Figures 4 and 5, the thickness of the InGaAs layer needs to be set to a small value of about 20 to 15 nm due to limitation by the critical layer thickness, in the case of the embodiment, the thickness of the InGaAs layer 8 can be set to a large value of, for example, about 30 nm. As a result, the controllability of the thickness of the InGaAs layer 8 is improved. In the case of growing the InGaAs layer 8 by MBE after the undoped GaAs layer 2 has been grown, there is no need suddenly to lower the growth temperature.

Since the junction between the InGaAs layer 8 and the GaAs layer 2 is a homojunction instead of a heterojunction, only a single heterojunction between the AlGaAs layer 3 and the InGaAs layer 8 exists in the embodiment. This reduces influence of alloy clusters.

In the above embodiment, the In concentration of the InGaAs layer 8 changes linearly, but it is possible to use any In concentration distribution such that the In concentration increases monotonically from the undoped GaAs layer 2 towards the n type AlGaAs layer 3. For example, distribution curve of the In concentration can be set to be upwardly convex or concave. In this case, the thickness of the InGaAs layer 8 is determined in accordance with the distribution curve of the In concentration. For instance, when the distribution curve of the In concentration is upwardly convex, the inclination of the energy band of the InGaAs layer 8 is large. Therefore, there is an advantage that a short channel effect can be effectively suppressed as compared with an n type AlGaAs/GaAs HEMT using no InGaAs layer, which also has a single heterojunction.

In the above embodiment, the In concentration of the InGaAs layer 8 at the interface with the AlGaAs layer 3 is set to 20%, but other values can be set. Thus there is a degree of freedom in changing the desired band shape of the InGaAs layer 8 for improving the characteristics of the HEMT. Moreover, the layers 2, 8, 3, and 4 can be grown by using a method other than MBE, for example, metalorganic chemical vapour deposition (MOCVD).

The present invention can be also applied to a so-called inverted HEMT in which the stacking order of the undoped GaAs layer 2 and the n type AlGaAs layer 3 is opposite to that in Figure 1. Further, the present invention is not limited to an n type AlGaAs/InGaAs/GaAs HEMT as in the above embodiment, but can also be applied to HEMTs using various semiconductor heterojunctions such as an n type InGap/InGaAs/GaAs HEMT.

## Claims

1. A compound semiconductor device having a channel layer (2) and an electron supply layer (3) and using a two-dimension electron gas (9), wherein said channel layer (2) near the interface between said channel layer (2) and said electron supply layer (3) is formed as a graded layer (8).

2. A device according to claim 1 wherein said graded layer (8) having a thickness equal to or less than the critical layer thickness is interposed between said channel layer (2) and said electron supply layer (3).

3. A device according to claim 2 wherein said channel layer (2), said electron supply layer (3) and said graded layer (8) are a GaAs layer, an n type AlGaAs layer, and an InGaAs layer, respectively.

4. A device according to claim 3 wherein the In concentration of said InGaAs layer (8) increases continuously towards said n type AlGaAs layer (3) from zero to a predetermined value.

5. A device according to claim 4 wherein said predetermined value is about 20%.

6. A device according to claim 3, claim 4 or claim 5 wherein the thickness of said InGaAs layer (8) is about 30 nm.

7. A device according to any one of claims 3 to 6 wherein said InGaAs layer (8) has been grown by molecular beam epitaxy.

# Fig. I

# Fig. 2

2 DEG

Ec

Ev

n AlGaAs    InGaAs    UNDOPED GaAs

# Fig. 3

In CONCENTRATION (%)

20

10

0

n AlGaAs    InGaAs    UNDOPED GaAs

# Fig. 4

Ec
2DEG

Ev

n AℓGaAs    InGaAs    UNDOPED GaAs

# Fig. 5

In CONCENTRATION (%)

20

10

0

n AℓGaAs    InGaAs    UNDOPED GaAs

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 740 822 (ITOH)<br>* Column 4, line 50 - column 5, line 66; figures 4-6 * | 1 | H 01 L 29/812<br>H 01 L 29/205 |
| A | | 2-4,7 | |
| A | INTERNATIONAL ELECTRON DEVICES MEETING, TECHNICAL DIGEST, Washington, D.C., 6th - 9th December 1987, pages 418-421, IEEE, New York, US; T. HENDERSON et al.: "Characterization of pseudomorphic InGaAs/AlGaAs MODFET structures grown by molecular beam epitaxy"<br>* Paragraphs: "Growth and characterization", "Discussion"; figure 1 * | 1-3,5,7 | |
| D,A | JAPANESE JOURNAL OF APPLIED PHYSICS, part 1, vol. 26, no. 4, April 1987, pages 539-542, Tokyo, JP; A. OKAMOTO et al.: "Strained N-Ga0.7Al0.3As/InxGa1-xAs/GaAs modulation-doped structures"<br>* Whole document * | 1-3,5,7 | |
| P,X | PATENT ABSTRACTS OF JAPAN, vol. 13, no. 396 (E-815)[3744], 4th September 1989; & JP-A-1 143 270 (MATSUSHITA ELECTRIC IND. CO. LTD) 05-06-1989<br>* Abstract; figures 1-3 * | 1-4 | TECHNICAL FIELDS SEARCHED (Int. Cl.5)<br><br>H 01 L |

The present search report has been drawn up for all claims

| Place of search | Date of completion of the search | Examiner |
|---|---|---|
| THE HAGUE | 08-05-1990 | MORVAN D.L.D. |

EPO FORM 1503 03.82 (P0401)